# EUROPÄISCHE PATENTSCHRIFT

(11) **EP 3 323 200 B1**
(45) Veröffentlichungstag und Bekanntmachung des Hinweises auf die Patenterteilung: **12.08.2020**
(21) Anmeldenummer: 16730349.4
(22) Anmeldetag: 15.06.2016
(51) Int. Cl.: H03H 9/02

(54) **BAUELEMENT MIT VERBESSERTER WÄRMEABLEITUNG**
COMPONENT WITH IMPROVED HEAT DISSIPATION
COMPOSANT À DISSIPATION THERMIQUE AMELIORÉE

(30) Priorität: 13.07.2015 DE 102015111307
(43) Veröffentlichungstag der Anmeldung: 23.05.2018
(73) Patentinhaber: SnapTrack, Inc., San Diego, CA 92121 (US)
(72) Erfinder: JEWULA, Tomasz, 85570 Markt Schwaben (DE); MEISTER, Veit, 82008 Unterhaching (DE)
(74) Vertreter: Hohgardt, Martin
(86) Internationale Anmeldenummer: PCT/EP2016/063748
(87) Internationale Veröffentlichungsnummer: WO 2017/008981

(56) Entgegenhaltungen:
- EP-A1- 1 139 412
- EP-A2- 2 555 239
- WO-A1-2014/029602
- US-A1- 2004 237 299
- US-A1- 2005 167 854
- US-A1- 2014 015 118
- US-B2- 7 940 146
- NISHIZAWA T ET AL: "Realization of small and low profile Duplexer using a CSSD packaging technology", ULTRASONICS SYMPOSIUM (IUS), 2009 IEEE INTERNATIONAL, IEEE, PISCATAWAY, NJ, USA, 20. September 2009 (2009-09-20), Seiten 903-906, XP031654547, ISBN: 978-1-4244-4389-5 in der Anmeldung erwähnt
- T. SUZUKI ET AL: "Analysis of heat dissipation improvement using bonded wafer in Chip Size SAW Device structure", 2013 IEEE INTERNATIONAL ULTRASONICS SYMPOSIUM (IUS), 1. Juli 2013 (2013-07-01), Seiten 1961-1964, XP055297468, DOI: 10.1109/ULTSYM.2013.0500 ISBN: 978-1-4673-5684-8 in der Anmeldung erwähnt

## Beschreibung

Das Dokument T. Nishizawa, G. Endo, M. Tajima, S. Ono and O. Kawachi, "Realization of small and low profile Duplexer using a CSSD packaging technology," 2009 IEEE International Ultrasonics Symposium, Rome, 2009, pp. 903-906 (doi: 10.1109/ULTSYM.2009.5441641) betrifft die Konstruktion von Duplexern, die sich durch eine kleine räumliche Größe, hohe Zuverlässigkeit und exzellente Leistungsfähigkeit auszeichnen. Das Dokument beschreibt die Vorteile von "Chip Size SAW Devices (CSSD)"-Strukturen mit Blick auf Miniaturisierung und Zuverlässigkeit.

Das Dokument US 2014/0015118 A1 betrifft einen Halbleiterchip, der ein Halbleitersubstrat mit einer ersten Oberfläche und einer zweiten Oberfläche, eine integrierte Schaltung (IC) auf der ersten Oberfläche des Halbleitersubstrats und einen Wärmestrahlungsabschnitt auf der zweiten Oberfläche des Halbleitersubstrats umfasst. Der Wärmeabstrahlungsabschnitt umfasst Wärmeabstrahlungsmuster in einer Richtung senkrecht zur zweiten Oberfläche und eine Wärmeabstrahlungsschicht auf oberen Abschnitten der Wärmeabstrahlungsmuster. Die Wärmeabstrahlungsmuster umfassen eine Vielzahl von Aussparungen und eine Vielzahl von Vorsprüngen, und die Wärmeabstrahlungsschicht umfasst ein Metallmaterial und hat eine flache obere Oberfläche.

Das Dokument EP 2 555 239 A2 betrifft integrierte Schaltungen und dazugehörige Elektronik, insbesondere die Wärmeableitungseigenschaften von vertikal gestapelten Matrizen in Gehäusen und anderen Leiterplattenbaugruppen.

Die Erfindung wird durch die unabhängigen Ansprüche definiert. Die in einem mikroelektronischen Bauelement unter Last entstehende Eigenerwärmung kann zu mechanischen Verspannungen, zu vorzeitiger Materialermüdung oder auch zu einer unzulässigen Veränderung der Bauelementeigenschaften führen. Es wird daher bei elektronischen Bauelementen angestrebt, deren Eigenerwärmung zu reduzieren und insbesondere die Verlustwärme effektiv abzuleiten, um die Eigenschaften der elektronischen Komponente unter Last zu verbessern. Bei einem Oberflächenwellenbauelement (SAW Bauelement) können z.B. die Frequenz¬stabilität sowie die Fähigkeit der Signalüber¬tragung gesteigert werden.

Die Reduzierung der Eigenerwärmung in mikroelektronischen Bauelementen, die auf Substraten mit niedriger thermischer Leitfähigkeit hergestellt sind wie z.B. SAW Bauelemente, erfolgt durch verschiedene Maßnahmen. Eine der gängigen Methoden ist die Vergrößerung der Fläche von aktiven Bereichen im Bauelement, wodurch die Energiedichte und somit auch die Wärmeerzeugung reduziert werden.

Die Wärmeabfuhr wird oft auch durch zusätzliche Bumps verbessert, wie es z.B. aus T.Nishizawa, G.Endo, M.Tajima, S.Ono, O.Kawachi, "Realization of Small and Low Profile Duplexer Using A CSSD Packaging Technology", IEEE Ultrasonics Symposium, pp.903-906, 2009 bekannt ist.

Darüber hinaus gibt es auch Ansätze, die Wärmeabfuhr durch Ergänzung eines im oder am Bauelement eingesetzten Lagenstapels um thermisch gut leitfähige Schichten auf der aktiven Seite des Bauelements zu verbessern. Typischerweise werden dafür dielektrische Schichten (SiN, AlN, Al₂O₃) genutzt. Auch Metalle können für diesen Zweck eingesetzt werden, wenn sie von den elektrisch und/oder akustisch aktiven Bereichen des Bauteils durch eine Isolierschicht getrennt sind.

Aus der US 7,940,146 B2 ist es bekannt, solche zusätzlichen Metallschichten thermisch mit den Bumps zu verbinden, um die thermische Energie effizienter aus dem System abzuleiten.

Eine weitere aus einem Artikel von T.Suzuki, T.Nishizawa, O.Kawachi, "Analysis of Heat Dissipation Improvement using Bonded Wafer in Chip Size SAW Device Structure", IEEE Joint UFFC, EFTF and PFM Symposium, pp. 1961-1964, 2013 bekannte Maßnahme zur Reduzierung der Eigenerwärmung basiert auf dem Einsatz von mehrlagigen Substraten. Dabei wird eine relativ dünne funktionale Schicht, z.B. aus einem piezoelektrischen Material, auf einem Trägermaterial mit höherer thermischer Leitfähigkeit aufgeklebt. Durch die reduzierte Dicke der schlecht thermisch leitfähigen funktionalen piezoelektrischen Schicht wird der effektive Wirbelstrom im Bauteil erhöht und dadurch die Eigenerwärmung reduziert.

Aufgabe der vorliegenden Erfindung ist es, ein Verlustwärme erzeugendes Bauelement anzugeben, bei dem die Abführung der Verlustwärme verbessert ist und eine Aufheizung des Bauelements durch die Verlustwärme reduziert wird.

Diese Aufgabe wird erfindungsgemäß durch ein Bauelement nach Anspruch 1 gelöst. Vorteilhafte Ausgestaltungen der Erfindung gehen aus weiteren Ansprüchen hervor.

Während bei bekannten Bauelementen von aktiven Bauelementstrukturen erzeugte Verlustwärme im Wesentlichen über das Substrat, also in der Substratebene nach außen in das Package oder das Trägersubstrat abgeleitet wird, verwendet das erfindungsgemäße Bauelement ein auf die Rückseite des Bauelementsubstrats aufgebrachtes Wärmeleitmittel, welches einen wesentlich höheren Wärmeleitfähigkeitskoeffizienten als das Substrat aufweist. Die in den Bauelementstrukturen erzeugte Verlustwärme kann dann auf kürzestem Weg durch die Substratebene hindurch zum Wärmeleitmittel geführt werden. Dort wird sie parallel zur Substratebene weiter abgeleitet und schließlich über metallische Verbindungsmittel, mit denen die aktive Seite des Substrats auf einem Träger montiert ist, in den Träger abgeleitet.
Zumindest ein Teil des Wärmestroms wird dabei wieder durch das Substrat hindurch geführt. Die durch das Substrat geführte Weglänge des Wärmestroms gegenüber den beschriebenen bekannten Lösungen deutlich verkürzt, indem das Substrat strukturierte Bereiche aufweist, in denen die Schichtdicke des Substrats reduziert ist. Dadurch ist auch der vertikale Wärmetransport durch das Substrat hindurch in den strukturierten Bereichen des Substrats von den Bauelementstrukturen zum Wärmeleitmittel und/oder vom Wärmeleitmittel zu den Verbindungsmitteln gegenüber einem unstrukturierten Substrat. Wegen des besseren Wärmeleitkoeffizienten der Wärmeleitschicht erfolgt die Wärmeableitung besser und effektiver als ohne Wärmeleitschicht.

Insbesondere kann die Wärme aus dem Substrat im Bereich über beziehungsweise unter den Bauelementstrukturen abgeleitet werden. Die Ableitung erfolgt außerhalb des Substrats und sodass eine übermäßige Erwärmung des Substrats vermieden wird. Damit kann die Zuverlässigkeit des Bauelements erhöht, eine thermische Drift der Bauelementeigenschaften vermindert und die thermisch bedingten Alterungsprozesse des Bauelements verlangsamt werden. Dadurch kann die Lebensdauer des Bauelements wesentlich verlängert werden.

Gemäß einer Ausführungsform wird das Wärmeleitmittel auf der Rückseite zumindest so aufgebracht, dass es Bereiche über den Bauelementstrukturen mit Bereichen über den metallischen Verbindungsmitteln wärmeleitend verbindet und auf dieser Strecke den entsprechenden Weg innerhalb des Substrats parallel überbrückt. Auf diese Weise ist ein Ableitweg für die Wärme von den Bauelementstrukturen hin zu den metallischen Verbindungsmitteln garantiert. Der Teil des Wärmeableitwegs, der quer durch das Substrat führt, ist minimiert und der Weg von den Bauelementstrukturen hin zu den metallischen Verbindungsmitteln wird vorzugsweise auf dem kürzesten Weg, allerdings auf der Rückseite des Substrats vorgenommen.

Gemäß einer Ausführungsform sind die metallischen Verbindungsmittel mit einer Wärmesenke verbunden, die im Träger angeordnet ist. Der Träger selbst kann ein Teil der Bauelementverpackung, also des Packages sein und bildet zusammen mit dem Bauelement eine Einheit. Das Package kann jedoch noch weitere Komponente umfassen.

Üblicherweise weist der Träger auf der Unterseite, also der vom Bauelement weg weisenden Oberfläche metallische Verbindungsflächen auf, über die der Träger beziehungsweise das verkapselte Bauelement in eine Schaltungsumgebung, beispielsweise eine Leiterplatte montiert werden kann. Als Wärmesenken können ausgedehnte metallische Bereiche dienen, die aufgrund ihrer hohen Wärmekapazität auch bei hohen Wärmemengen eine nicht so starke Aufheizung aufzeigen wie Materialien mit geringerer Wärmekapazität. Bei elektrisch gut leitfähigen Materialien, so auch bei Wärmesenken, ist die weitere Wärmeabgabe deutlich erleichtert im Vergleich zu Materialien mit geringerer Wärmeleitfähigkeit.

Der Träger kann eine Schicht eines keramischen Materials umfassen. Der Träger kann mehrschichtig aufgebaut sein und Schichten unterschiedlicher Materialien umfassen. Ein mehrschichtiger Träger kann auch isolierende Kunststofflagen und dazwischen angeordnete strukturierte Metallisierungen aufweisen.

Die strukturierten Bereiche sind im Bereich der Bauelementstrukturen und/oder im Bereich der metallischen Verbindungsmittel vorgesehen. Durch die strukturierten Bereiche wird der Wärmetransport gezielt an den Stellen erleichtert, an denen die Wärme entsteht beziehungsweise wo sie wieder über die metallischen Verbindungsmittel abgeleitet werden soll. Die strukturierten Bereiche erleichtern also den Wärmetransport durch das Substrat hindurch gezielt an den entscheidenden und wichtigen Stellen.

Eine Möglichkeit, den Wärmetransport in den strukturierten Bereichen zu erleichtern besteht darin, die Schichtdicke des Substrats in den strukturierten Bereichen zu reduzieren. Dazu können Ausnehmungen in der Rückseite des Substrats vorgesehen sein. In den Ausnehmungen kann die Dicke des Substrats bis auf eine für die Funktion des Bauelements notwendige Dicke reduziert werden. Da die Schichtdicke nur in flächenmäßig begrenzten Bereichen reduziert wird, kann sie in den Ausnehmungen dünner sein, als es aus mechanischen Gründen für das gesamte Substrat erlaubt ist. Damit wird der Weg durch das Material mit dem ersten und geringeren Wärmeleitfähigkeitskoeffizienten minimiert.

In einer Ausführung umfasst das Substrat ein piezoelektrisches Material und das Bauelement selbst ist ein mit akustischen Wellen arbeitendes Bauelement, insbesondere ein mit akustischen Oberflächenwellen arbeitendes Bauelement. Hier kann die Erfindung besonders vorteilhaft eingesetzt werden, da die üblicherweise verwendeten piezoelektrischen Materialien schlechte beziehungsweise niedrige Wärmeleitfähigkeitskoeffizienten α_{S} aufweisen. Darüber hinaus reagieren mit akustischen Wellen arbeitende Bauelemente besonders empfindlich auf Erwärmung und zeigen eine Temperaturdrift der Frequenz, ausgedrückt durch den TCF (Temperaturkoeffizient der Mittenfrequenz).

Ein mit akustischen Wellen arbeitendes Bauelement ist beispielsweise ein Filter, welches einen Filtereingang und diesem zugewiesene Bauelementstrukturen sowie einen Filterausgang und diesem zugewiesene weitere Bauelementstrukturen aufweist. Findet zwischen den dem Eingang und dem Ausgang zugeordneten Bauelementstrukturen oder deren Zuleitungen oder Anschlussflächen eine Kopplung statt, so können an den Eingang angelegte elektrische Signale direkt in den Ausgang, und in die mit dem Ausgang verbundenen Strukturen einkoppeln und dort Störsignale verursachen.

Eine ganzflächig auf der Rückseite des Substrats aufliegende elektrisch leitende Schicht wie die Wärmeleitschicht könnte dann unter Umständen zu einem Übersprechen führen, indem sie eine kapazitive Kopplung zwischen Ein- und Ausgangsstrukturen bewirkt.

Gemäß einer Ausführungsform wird ein solches Übersprechen vermieden, indem die als Wärmeleitmittel aufgebrachte elektrisch leitende Schicht in zwei oder mehr galvanisch voneinander getrennte Bereiche strukturiert wird, wobei jeweils ein Bereich über den Bauelementstrukturen der Eingangsseite und ein Bereich über den Bauelementstrukturen der Ausgangsseite angeordnet ist. Auf diese Weise wird keine zusätzliche kapazitive Kopplung durch die elektrisch leitende Schicht des Wärmeleitmittels erzeugt.

Prinzipiell kann das Wärmeleitmittel auch eine ganzflächig auf der Rückseite des Substrats aufgebrachte Schicht umfassen, die metallisch sein kann, wenn kein Übersprechen zu befürchten ist. Vorzugsweise jedoch ist die ganzflächige Schicht aus den genannten Gründen aus einem elektrisch isolierten Material oder einem Halbleiter.

In einer weiteren Ausführungsform ist die als Wärmeleitmittel auf der Rückseite des Substrats aufgebrachte Schicht an zumindest einer Seitenfläche des Substrats bis zum Träger hinunter verlängert und dort mit einer Wärmesenke, die auf oder im Träger angeordnet ist, verbunden. Auf diese Weise kann der Wärmefluss von der Schicht des Wärmeleitmittels durch das Substrat hindurch hin zu den Verbindungsmitteln durch wärmeleitende Überbrückung reduziert werden und die Wärmeableitung kann schneller und besser erfolgen.

Die metallischen Verbindungsmittel können als Bumps oder LotStellen ausgebildet sein und verbinden Kontaktflächen auf dem Substrat mit entsprechenden Anschlussstellen auf der Oberseite des Trägers. In beiden Fällen sind die Verbindungsmittel metallisch und besitzen daher einen hohen Wärmeleitfähigkeitskoeffizienten Alpha.

In einer weiteren Variante ist es möglich, zusätzlich zu den für den elektrischen Anschluss der Bauelementstrukturen bzw. des Bauelements selbst erforderlichen Verbindungsmittel weitere Verbindungsmittel vorzusehen, die allein der Wärmeabführung dienen. Dies kann insbesondere dann vorteilhaft sein, wenn im Bauelement beziehungsweise im Substrat besonders viel Wärme erzeugt wird und noch ausreichend Substratoberfläche für diese zusätzlichen nur der Wärmeableitung dienenden Verbindungsmittel zur Verfügung steht. Die weiteren Verbindungsmittel können mit Bauelementstrukturen elektrisch verbunden sein. Vorzugsweise sind sie gegen die Bauelementstrukturen elektrisch isoliert.

Das Wärmemittel kann ein Material umfassen, das ausgewählt ist aus Aluminium, Silber, Kupfer, Gold oder aus elektrisch isolierten Materialien wie Aluminiumnitrid und Siliziumcarbid.

Im Folgenden wird die Erfindung anhand von Ausführungsbeispielen und der dazugehörigen Figuren näher erläutert. Die Figuren sind rein schematisch und nicht maßstabsgetreu ausgeführt. Den Figuren sind daher weder absolute noch relative Maßangaben zu entnehmen, da einzelne Teile zur besseren Verdeutlichung auch vergrößert dargestellt sein können.
- Figur 1: zeigt im Querschnitt ein an sich bekanntes mit akustischen Oberflächenwellen arbeitendes Bauelement samt den Wegen, auf denen die erzeugte Verlustwärme abfließt,
- Figur 2: zeigt ein Beispiel, das nicht in allen Aspekten mit der Erfindung übereinstimmt, anhand eines schematischen Querschnitts durch ein Bauelement,
- Figur 3: zeigt ein Beispiel, das nicht in allen Aspekten mit der Erfindung übereinstimmt, anhand eines Querschnitts,
- Figur 4: zeigt eine Ausführungsform mit ersten strukturierten Bereichen anhand eines schematischen Querschnitts,
- Figur 5: zeigt eine Ausführungsform mit ersten und weiteren strukturierten Bereichen im schematischen Querschnitt,
- Figur 6: zeigt ein weiteres Beispiel, das nicht in allen Aspekten mit der Erfindung übereinstimmt, im schematischen Querschnitt,
- Figur 7: zeigt die Temperatur eines Messpunktes eines bekannten Bauelements in Abhängigkeit von der Frequenz des angelegten elektrischen Signals,
- Figur 8: zeigt die Temperatur eines Messpunktes eines erfindungsgemäßen Bauelements in Abhängigkeit von der Frequenz des angelegten elektrischen Signals.

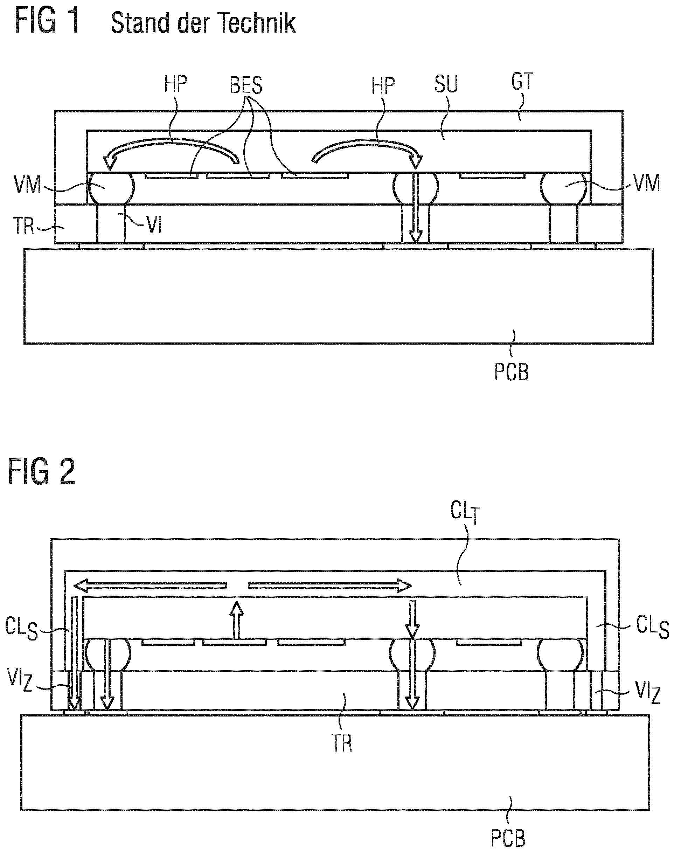

Figur 1 zeigt ein an sich bekanntes Bauelement, welches mit akustischen Oberflächenwellen arbeitet, also ein SAW-Bauelement (SAW = Surface Acoustic Wave). Dieses umfasst ein piezoelektrisches Substrat SU, welches in Flipchip-Bauweise über als Verbindungsmittel VM dienende Bumps auf einen zum Beispiel eine keramische Platte umfassenden Träger TR aufgebondet ist. Auf der aktiven Seite des Substrats SU, die zum Träger TR hinweist, sind schematische Bauelementstrukturen BES in Form von Metallisierungen angedeutet. Nicht dargestellt sind elektrische Verbindungen, die die Bauelementstrukturen BES mit Kontaktflächen auf der aktiven Seite des Substrats SU verbinden. Die Kontaktflächen dienen zur elektrischen und mechanischen Ankopplung mittels hier als Bumps ausgeführter Verbindungsmittel VM. Das Bauelement kann darüber hinaus mit einer Schutzschicht GT geschützt sein, beispielsweise mit einer Globe Top-Beschichtung, die ein Epoxidharz umfasst. Über diese Beschichtung kann ein Hohlraum zwischen der aktiven Seite des Substrats SU und dem Träger TR, innerhalb dem die Bauelementstrukturen BES angeordnet sind, hermetisch abgedichtet sein.

Wie aus der Figur ersichtlich, ist das Bauelement über elektrische Anschlüsse an der Unterseite des Trägers TR mit einer Leiterplatte PCB elektrisch und mechanisch verbunden, beispielsweise verlötet.

Innerhalb des Substrats SU ist durch gebogene Pfeile der Wärmefluss angedeutet, mit dem sich die durch die Bauelementstrukturen BES erzeugte Verlustwärme innerhalb der Schichtebene des Substrats SU über das Substrat erstreckt und schließlich über die Verbindungsmittel VM hin zum Träger TR und weiter zur Leiterplatte PCB abgeleitet wird. Aufgrund des schlechten Wärmeleitfähigkeitskoeffizienten α_{S} des piezoelektrischen Substrats SU kann es zu einer starken Erwärmung des Substrats kommen. Der Wärmeabfluss ist verzögert und das Bauelement kann sich überhitzen.

Figur 2 zeigt ein Beispiel, das nicht in allen Aspekten mit der Erfindung übereinstimmt, anhand eines schematischen Querschnitts durch ein Bauelement. Auch hier ist wieder ein piezoelektrisches Substrat SU über Verbindungsmittel VM (Bumps) auf einem Träger TR montiert, welcher wiederum auf einer Leiterplatte PCB aufgebracht ist. Die Rückseite des Substrats SU ist aber mit einer Schicht eines Wärmeleitmittels CL_{T} beschichtet, beispielsweise mit einer metallischen Schicht. Diese Schicht des Wärmeleitmittels erstreckt sich hier auch über einen Abschnitt CL_{S}, welcher über die Seitenflächen des Substrats SU hinab bis zum Träger TR reicht. Im Träger wiederum ist die Schicht des leitfähigen Materials CL beziehungsweise deren seitlicher Abschnitt CL_{S} mit einer zusätzlichen Durchkontaktierung VI_{Z} bzw. einem Via VI verbunden, welche ebenfalls aufgrund ihrer metallischen Auskleidung oder Füllung gut wärmeleitfähig ist und einen guten Wärmetransport durch den Träger TR ermöglicht. Die zusätzliche Durchkontaktierung VI_{Z} kann allein für den Wärmetransport vorbehalten bleiben. Möglich ist es jedoch auch, die zusätzliche Durchkontaktierung VI_{Z} mit Massepotential zu verbinden.

Auch hier ist der Wärmefluss schematisch anhand von Pfeilen dargestellt. Es zeigt sich, dass ein Wärmefluss nun überwiegend von den Bauelementstrukturen quer durch das Substrat SU hindurch bis in die Schicht des wärmeleitfähigen Materials CL_{T} erfolgt. Innerhalb dieser Schicht erfolgt ein schneller Wärmetransport, so dass bei einem Betrieb des Bauelements unter Last eine schnelle Wärmeverteilung und damit eine gleichmäßige Aufheizung des Wärmeleitmittels CL erfolgt. Entsprechend gleichmäßiger ist auch die Aufheizung des Substrats.

Von der Schicht des Wärmeleitmittels CL_{T} auf der Rückseite des Substrats SU wird die Wärme auf zwei Wegen hin zum Träger TR und weiter zur Leiterplatte PCB auf zwei prinzipiell verschiedenen Pfaden abgeleitet. Ein erster Pfad erstreckt sich von dem Wärmeleitmittel quer durch das Substrat hindurch hin zu einem Verbindungsmittel und über das Verbindungsmittel zu einer Durchkontaktierung durch den Träger TR hin zur Leiterplatte PCB. Der weitere bereits beschriebene Wärmeableitpfad findet durch die seitlichen Abschnitte CL_{S} des Wärmeleitmittels hin zu entsprechenden Durchkontaktierungen im Träger statt.

Das dargestellte Bauelement zeigt eine effiziente Wärmeableitung und eine verringerte Temperaturerhöhung unter Last. Mithin ist es in seiner Frequenzgenauigkeit, der Alterungsbeständigkeit und der Zuverlässigkeit gegenüber dem in Figur 1 dargestellten bekannten Bauelement verbessert.

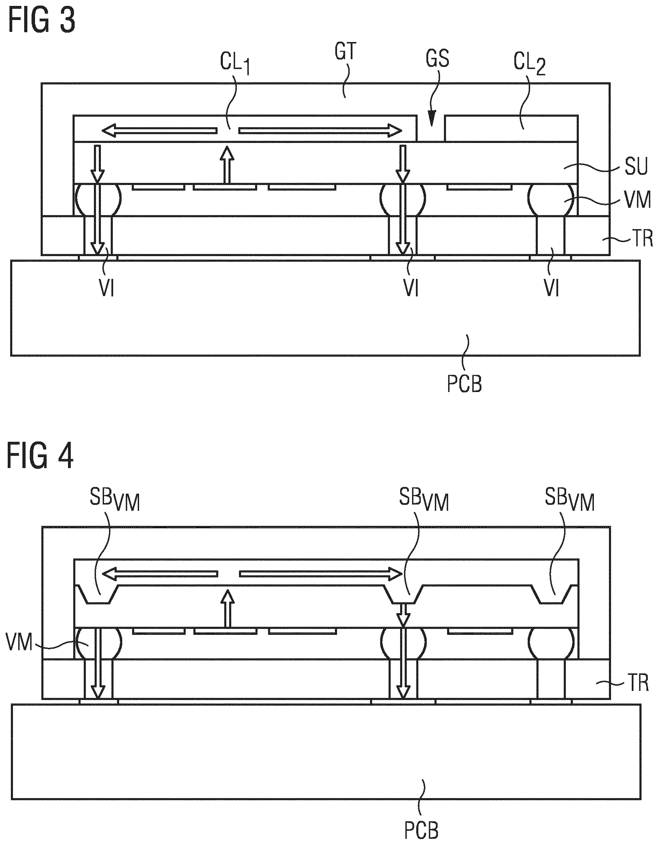

Figur 3 zeigt ein weiteres Beispiel, das nicht in allen Aspekten mit der Erfindung übereinstimmt, bei dem die auf die Rückseite des Substrats aufgebrachte Schicht des Wärmeleitmittels CL in zwei Bereiche CL₁ und CL₂ unterteilt ist. Die beiden Bereiche sind galvanisch durch eine galvanische Trennung GS voneinander getrennt, so dass eine kapazitive Kopplung unterschiedlicher Bauelementstrukturen über eine durchgängige, elektrisch leitende Schicht an Wärmeleitmittel vermieden wird. Obwohl nicht dargestellt, kann auch hier die Schicht des Wärmeleitmittels CL1, CL2 über entsprechende seitliche Abschnitte über die Seitenflächen des Substrats SU hin zum Träger weitergeführt werden, um auch auf diesem Weg eine zusätzliche Wärmeableitung zu ermöglichen.

Figur 4 zeigt ein Ausführungsbeispiel der Erfindung. Im Gegensatz zur Figur 3 ist hier das Wärmeleitmittel als ganzflächige Schicht auf die Rückseite des Substrats SU aufgebracht. Um den Wärmepfad durch das Substrat hindurch, welches einen schlechten ersten Wärmeleitfähigkeitskoeffizienten α_{S} aufweist, zu verkürzen, ist in strukturierten Bereichen SB_{VM} die Schichtdicke des Substrats SU reduziert. Diese strukturierten Bereiche SB_{VM} sind in dieser Ausführungsform ausschließlich über den Verbindungsmitteln VM angeordnet und nicht über akustisch aktiven Bauelementstrukturen BES, so dass deren Funktion durch die reduzierte Schichtdicke in den strukturierten Bereichen SB_{VM} nicht gestört ist.

Der Wärmepfad erstreckt sich daher nun vom Punkt der Wärmeerzeugung an den Bauelementstrukturen BES quer durch das Substrat SU hindurch in die wärmeleitfähige Schicht CL_{T}, dort seitlich bis hin zu den strukturierten Bereichen SB und dort durch die reduzierte Schichtdicke des Substrats SU hindurch hin zu den Verbindungsmitteln VM und über diese in den Träger TR hinein. Da der Abschnitt durch das Substrat hindurch, also der Abschnitt des Wärmepfads durch das Material mit dem geringsten Wärmeleitfähigkeitskoeffizienten α_{S} gegenüber den vorherigen Beispielen verkürzt ist, erfolgt hier eine verbesserte Wärmeabfuhr über die strukturierten Bereiche und die darunter angeordneten Verbindungsmittel VM.

In einem Ausführungsbeispiel ist z.B. Das Substratmaterial LiNbO₃, welches einen Wärmeleitfähigkeitskoeffizienten α_{S} von 4,6 W/mK besitzt. Der Wärmeleitfähigkeitskoeffizient einer aus Epoxid bestehenden Abdeckung GT beträgt sogar nur 0,5 W/mK. Der Wärmeleitfähigkeitskoeffizient α_{LS} einer Schicht des Wärmeleitmittels CL aus beispielsweise Aluminium dagegen beträgt 237 W/mK, ist also ungefähr 50-mal so groß.

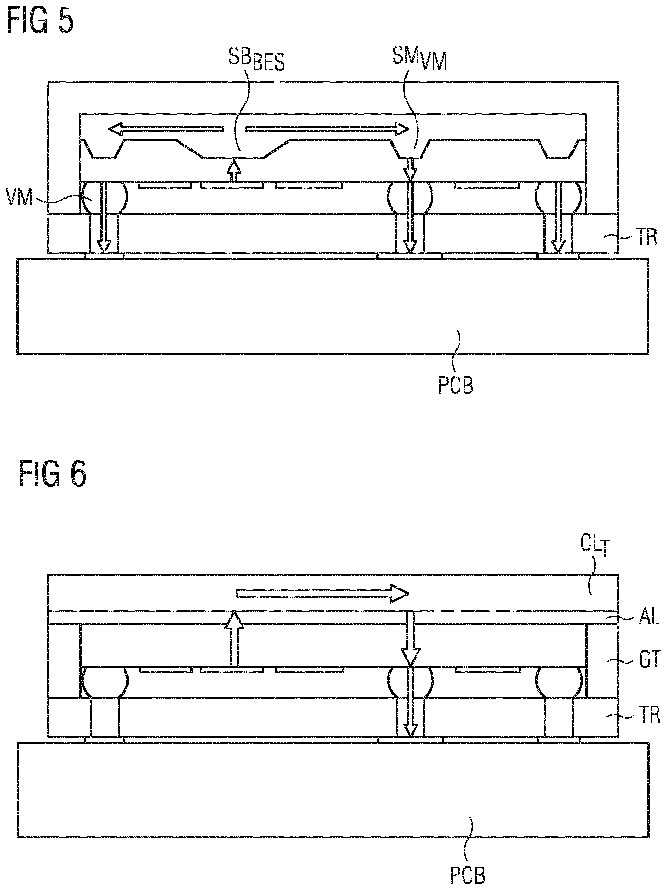

Figur 5 zeigt im schematischen Querschnitt ein Bauelement nach einer weiteren Ausführungsform, bei der an der Rückseite des Substrats sowohl erste strukturierte Bereiche SB_{VM} über den Verbindungsmitteln VM als auch zweite strukturierte Bereiche SB_{BES} über den Bauelementstrukturen BES platziert sind. Diese beiden strukturierten Bereiche können sich durch die Tiefe der Ausnehmung und die reduzierte Schichtdicke des Substrats unterscheiden. Weiterhin kann die Ausnehmung über den Bauelementstrukturen BES großflächiger sein, um über den gesamten Bereich der Bauelementstrukturen eine reduzierte Schichtdicke zu ermöglichen. Die Schichtdicke des Substrats kann über den Bauelementstrukturen BES größer sein als über den Verbindungsmitteln VM.

Da hier nun der Weg von den Bauelementstrukturen in das Wärmeleitmittel hinein sowie der Weg vom Wärmeleitmittel durch das Substrat hindurch in die Verbindungsmittel VM verkürzt ist, ist die Wärmeableitung des Bauelements nach dem Ausführungsbeispiel gegenüber dem in Figur 4 dargestellten Ausführungsbeispiel weiter verbessert. Durch die Strukturierung in einem relativ geringen Flächenanteil des Substrats ist die Stabilität des Substrats durch die Ausnehmungen nicht unzulässig erniedrigt. Eine Bruchgefahr ist ausgeschlossen, zumal auch die elektrisch leitfähige Schicht beziehungsweise die Schicht des Wärmeleitmittels formschlüssig auf dem der Rückseite des Substrats aufgebracht ist und so dessen Strukturfestigkeit verstärkt. Obwohl nicht dargestellt, kann auch hier die Schicht des Wärmeleitmittels CL sich über die Seitenflächen des Substrats hin zum Träger erstrecken, um eine direkte Wärmeableitung zu ermöglichen, die nicht ausschließlich durch das Substrat hindurch erfolgen muss.

In vorangegangenen Ausführungsbeispielen und Beispielen ist die Schicht des Wärmeleitmittels CL vorzugsweise formschlüssig auf die Rückseite des Substrats SU aufgebracht. Dies kann durch eine geeignete Metallisierung, beispielsweise eine über die Gasphase erzeugte Grundmetallisierung und eine galvanische oder stromlose Verstärkung derselben aufgebracht werden.

Möglich ist es jedoch auch, wie in einem weiteren Beispiel, das nicht in allen Aspekten mit der Erfindung übereinstimmt, anhand der Figur 6 dargestellt, das Wärmeleitmittel CL_{T} als kompakte Schicht auf die Rückseite des Substrats SU aufzukleben. Als Klebstoff wird dabei vorzugsweise ein mit thermisch gut leitfähigen Partikeln gefüllter Kleber verwendet, der dadurch insgesamt eine gute Wärmeleitfähigkeit aufweist.

Durch Aufkleben des Wärmeleitmittels in Form eines Blechs oder einer Folie kann der Schritt der Metallabscheidung oder der Abscheidung eines isolierenden Wärmeleitmittels aus der Gasphase eingespart werden. Gleichzeitig kann die aufgeklebte Schicht des Wärmeleitmittels einen Teil der Versiegelung beziehungsweise der Schutzschicht oder des Packages des Bauelements darstellen. In der Figur dargestellt sind Randbereiche einer Schutzschicht GT, die das Substrat seitlich begrenzen und den Hohlraum zwischen Träger und Substrat hermetisch abdichten. Bündig auf diesen Seitenteilen sitzt dann das Wärmeleitmittel CL_{T} und ist mit Hilfe des Klebstoffs beziehungsweise der Klebstoffschicht AL dicht mit dem Substrat verbunden. Auch dieses Vorgehen kann mit anderen Ausführungsbeispielen kombiniert werden, ohne dass von der Idee der Erfindung abgewichen werden muss.

Die Schicht des Wärmeleitmittels, die gegenüber bekannten Bauelementen eine zusätzliche ist, kann in einem Schritt erzeugt oder aufgebracht werden, der sich problemlos in den Herstellungsprozess des Bauelements integrieren lässt. Die Gefahr einer unzulässigen Eigenerwärmung von Bauelementen kann mit der Erfindung daher kostengünstig reduziert werden und führt in kostengünstiger Weise zu Bauelementen mit verbesserter thermischer Stabilität, geringerer Drift der Eigenschaften durch geringere Eigenerwärmung sowie zu einer verlängerten Lebensdauer und einer erhöhten Zuverlässigkeit.

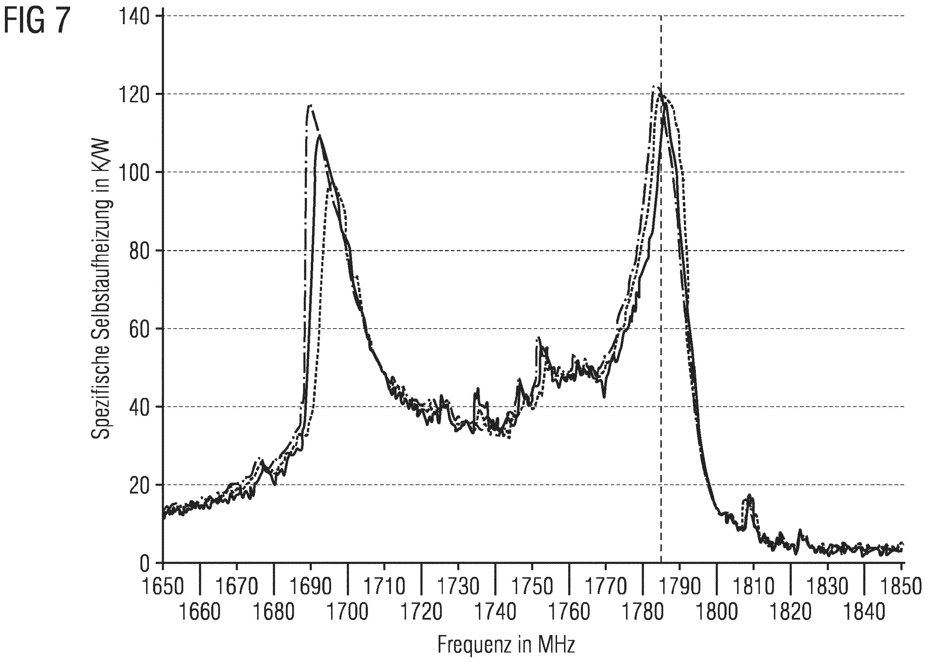

Figur 7 zeigt die gemessene Temperaturzunahme eines Messpunkts auf dem Substrat eines bekannten Bauelements in K/W in Abhängigkeit von der Frequenz eines an die Bauelementstrukturen angelegten elektrischen Signals. In der Figur sind drei bei verschiedenen Leistungen bestimmte Kurven übereinander gelegt.

Das Bauelement ist hier ein Duplexer für Band 3. Es zeigt sich, dass bei Resonanzfrequenzen des Duplexers besonders viel Verlustwärme entsteht, die die Temperatur um bis zu ca. 120°C ansteigen lassen kann. Bei einem Temperaturkoeffizienten der Mittenfrequenz des verwendeten Substratmaterials von 27,1 ppm/K entspricht das einer Frequenzverschiebung von ca. 2700 ppm entsprechend einer absoluten Frequenzverschiebung von ca. 5,8 MHz. Die höchste durch Verlustwärme und Aufheizung bedingte Erwärmung wird bei einer Frequenz von 1785MHz gemessen, die der rechten Passbandflanke entspricht.

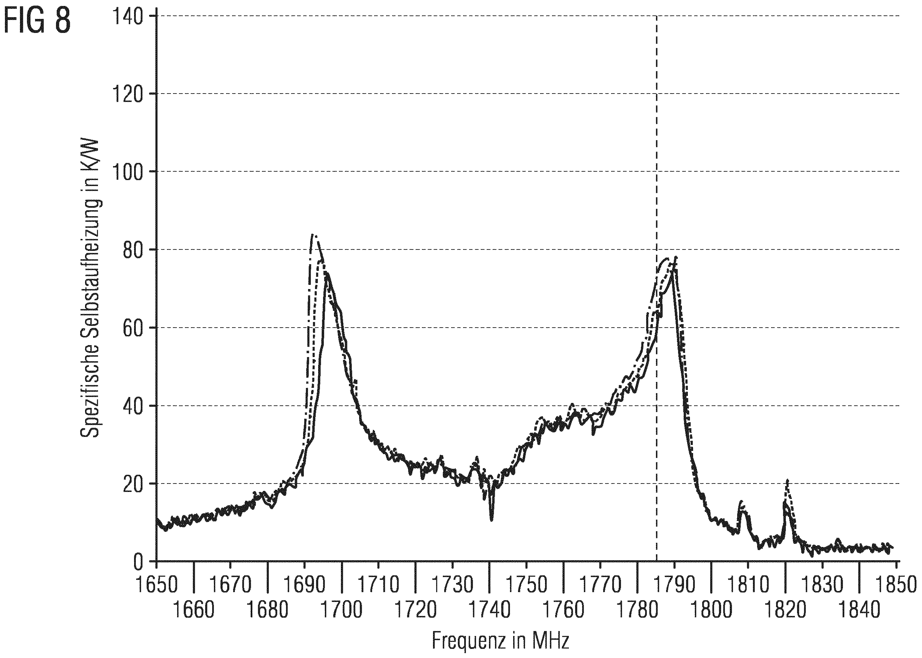

Figur 8 zeigt die gemessene Temperaturzunahme eines Messpunkts auf dem Substrat eines erfindungsgemäßen Bauelements in K/W in Abhängigkeit von der Frequenz eines an die Bauelementstrukturen angelegten elektrischen Signals. In der Figur sind drei bei verschiedenen Leistungen bestimmte Kurven übereinander gelegt.

Das Bauelement ist hier wieder der Duplexer für Band 3, der allerdings wie in Figur 6 dargestellt mit einer aufgeklebten Aluminiumfolie ausgeführt ist. Die größte Erwärmung bzw. Temperaturzunahme zeigt sich wieder im Bereich der rechten Passbandflanke, ist aber bei ansonsten gleichen Messbedingungen wesentlich geringer um erreicht nur ca. 75°C. Mit dem gleichen Temperaturkoeffizienten ergibt sich hier eine temperturbedingte Frequenzdrift von ca. 3,6 MHz, also eine Reduktion um 38%.

Obwohl die Erfindung nur für mit akustischen Wellen arbeitende Bauelemente beschrieben, ist die Erfindung jedoch für alle elektrischen und mikroelektronischen Bauelemente geeignet, die in Flipchip-Anordnung auf einem Träger aufgebracht sind und die ein Substrat mit schlechter Wärmeleitung, also mit niedrigem Wärmeleitfähigkeitskoeffizienten aufweisen. Die Erfindung ist auch daher nicht auf die Ausführungsbeispiele beschränkt.

Die Erfindung ist auf verschiedene Bauelementtypen anwendbar, kann an verschiedene Gehäusetechnologien angepasst werden, kann geometrisch anders als dargestellt ausgeformt sein und mit unterschiedlichen Materialien bezüglich Träger, Substrat oder auch Leiterplatte kombiniert werden. Ein erfindungsgemäßes Bauelement kann darüber hinaus weitere Abdeckschichten umfassen, die über oder unter den beschriebenen Abdeckschichten angeordnet sein können.

### Bezugszeichenliste

- AL: Klebstoffschicht
- BES: Bauelementstrukturen auf aktiver Seite
- CL_{S}: Wärmeleitmittel seitlich an Substrat
- CL_{T}, CL₁, CL₂: Wärmeleitmittel auf Rückseite
- GS: galvanische Trennung
- GT: Abdeckung/Schutzschicht
- PCB: Leiterplatte
- SB_{BES}: strukturierte Bereiche des Substrats über Bauelementstrukturen
- SB_{VM}: strukturierte Bereiche des Substrats über Verbindungsmittel
- SU: Substrat
- TR: Träger
- VI: Via oder Durchkontaktierung
- VI_{Z}: zusätzliches Via oder Durchkontaktierung für
- VM: metallische Verbindungsmittel Wärmeableitung
- α_{LS}: zweiter Wärmeleitfähigkeitskoeffizient (Wärmeleitmittel)
- α_{S}: erster Wärmeleitfähigkeitskoeffizient (Substrat)

## Patentansprüche

1. Bauelement
- mit einem Substrat (SU) mit einem ersten Wärmeleitfähigkeitskoeffizienten α_{S},
- mit Verlustwärme erzeugende Bauelementstrukturen (BES) auf einer aktiven Seite des Substrats,
- mit einem Träger (TR),
- mit metallischen Verbindungsmitteln (VM), mit denen die aktive Seite des Substrats auf dem Träger montiert ist,
- mit einem Wärmeleitmittel (CL_{T}, CL₁, CL₂), das auf der Rückseite des Substrats aufgebracht ist, die der aktiven Seite gegenüber liegt,
- wobei das Wärmeleitmittel ein Material aufweist, das einen zweiten Wärmeleitfähigkeitskoeffizienten α_{LS} aufweist,
- wobei α_{LS} > > α_{S},
- bei dem der vertikale Wärmetransport durch das Substrat hindurch in strukturierten Bereichen des Substrats von den Bauelementstrukturen (SB_{BES}) zum Wärmeleitmittel und/oder vom Wärmeleitmittel zu den Verbindungsmitteln (SB_{VM}) gegenüber den übrigen Bereichen des Substrats erleichtert ist,
- bei dem die Schichtdicke des Substrats in den strukturierten Bereichen reduziert ist.

2. Bauelement nach Anspruch 1,
bei dem das Wärmeleitmittel auf der Rückseite des Substrats zumindest den oder die Bereiche über den Bauelementstrukturen mit den Bereichen über den metallischen Verbindungsmitteln verbindet.

3. Bauelement nach einem der vorangehenden Ansprüche,
bei dem die metallischen Verbindungsmittel mit einer Wärmesenke im Träger verbunden sind.

4. Bauelement nach einem der vorangehenden Ansprüche,
bei dem das Substrat ein piezoelektrisches Material umfasst
bei dem das Bauelement ein mit akustischen Wellen arbeitendes Bauelement ist.

5. Bauelement nach Anspruch 4,
bei dem das Wärmeleitmittel eine auf der Rückseite des Substrats aufgebrachte elektrisch leitende Schicht umfasst, die in zwei voneinander getrennte Bereiche strukturiert ist, die über unterschiedlichen Bauelementstrukturen angeordnet sind, so dass eine kapazitive Kopplung der unterschiedlicher Bauelementstrukturen durch die Schicht des Wärmeleitmittels vermieden wird.

6. Bauelement nach einem der Ansprüche 1-4,
bei dem das Wärmeleitmittel eine ganzflächig auf der Rückseite des Substrats aufgebrachte Schicht umfasst.

7. Bauelement nach einem der vorangehenden Ansprüche,
bei dem die als Wärmeleitmittel auf der Rückseite des Substrats aufgebrachte Schicht an zumindest einer Seitenfläche des Substrats bis zum Träger hinunter reicht und dort mit einer Wärmesenke verbunden ist.

8. Bauelement nach einem der vorangehenden Ansprüche,
bei dem die metallischen Verbindungsmittel als Bumps oder Lotstellen ausgebildet sind, die Kontaktflächen auf dem Substrat mit entsprechenden Anschlussstellen auf der Oberseite des Trägers verbinden.

9. Bauelement nach einem der vorangehenden Ansprüche,
bei dem das Wärmeleitmittel ein Material umfasst, ausgewählt aus Al, Ag, Cu, Au, AlN und SiC.

## Claims

1. Component
- with a substrate (SU) having a first thermal conductivity coefficient as,
- with component structures (BES) generating dissipation heat on an active side of the substrate,
- with a carrier (TR),
- with metallic connecting means (VM), with which the active side of the substrate is mounted on the carrier,
- with a heat-conducting means (CL_{T}, CL₁, CL₂) applied to the back side of the substrate located opposite to the active side,
- wherein the heat-conducting means comprises a material having a second thermal conductivity coefficient α_{LS},
- wherein α_{LS} >> α_{S},
- in which the vertical heat transport through the substrate in structured areas of the substrate from the component structures (SB_{BES}) to the heat-conducting means and/or the heat-conducting means to the connecting means (SB_{VM}) with respect to the remaining regions of the substrate is facilitated,
- in which the layer thickness of the substrate is reduced in the structured areas.

2. Component according to claim 1,
in which the heat-conducting means on the back side of the substrate connects at least one or the plurality of areas above the component structures to the areas above the metallic connecting means.

3. Component according to any of the preceding claims, in which the metallic connecting means are connected to a heat sink in the carrier.

4. Component according to any of the preceding claims,
in which the substrate comprises a piezoelectric material, in which the component is a component working with acoustic waves.

5. Component according to claim 4,
in which the heat-conducting means comprises an electrically conductive layer applied on the back side of the substrate, which is structured in two separate areas, which are arranged above different component structures, so that a capacitive coupling of the different component structures through the layer of the heat conducting means is avoided.

6. Component according to any of the claims 1-4,
in which the heat-conducting means comprises a layer applied across the entire surface area on the back side of the substrate.

7. Component according to any of the preceding claims,
in which the layer applied as a heat-conducting means on the back side of the substrate extends down to at least one side surface of the substrate towards the carrier and is connected there to a heat sink.

8. Component according to any of the preceding claims,
in which the metallic connecting means are formed as bumps or solder pads, which connect contact surfaces on the substrate with corresponding connection points on the upper side of the carrier.

9. Component according to any of the preceding claims,
wherein the heat-conducting means comprises a material selected from Al, Ag, Cu, Au, AlN and SiC.

## Revendications

1. Composant, doté
- d'un substrat (SU) ayant un premier coefficient de conductivité thermique α_{S},
- de structures de composant (BES) générant une dissipation thermique sur une face active du substrat,
- d'un support (TR),
- de moyens de liaison métalliques (VM) grâce auxquels la face active du substrat est montée sur le support,
- d'un moyen de conduction thermique (CL_{T}, CL₁, CL₂) qui est déposé au dos du substrat opposée à la couche active,
- ledit moyen de conduction thermique présentant un matériau qui présente un second coefficient de conduction thermique α_{LS},
- où α_{LS} >> α_{S},
- dans lequel le transport thermique vertical à travers le substrat dans des zones structurées du substrat depuis les structures de composant (SB_{BES}) jusqu'au moyen de conduction thermique et/ou depuis le moyen de conduction thermique jusqu'aux moyens de liaison (SB_{VM}) est facilité par rapport aux autres zones du substrat,
- dans lequel l'épaisseur de couche du substrat est réduite dans les zones structurées.

2. Composant selon la revendication 1,
dans lequel le moyen de conduction thermique au dos du substrat relie au moins la ou les zones au-dessus des structures de composant avec les zones au-dessus des moyens de liaison métalliques.

3. Composant selon l'une des revendications précédentes, dans lequel les moyens de liaison métalliques sont reliés à un puits de chaleur dans le support.

4. Composant selon l'une des revendications précédentes, dans lequel le substrat comprend un matériau piézoélectrique,
dans lequel le composant est un composant fonctionnant avec des ondes acoustiques.

5. Composant selon la revendication 4,
dans lequel le moyen de conduction thermique comprend une couche électriquement conductrice déposée au dos du substrat, qui est structurée en deux zones séparées l'une de l'autre, qui sont disposées au-dessus de différentes structures de composant de manière à éviter un couplage capacitif des différentes structures de composant par l'intermédiaire de la couche du moyen de conduction thermique.

6. Composant selon l'une des revendications 1 à 4,
dans lequel le moyen de conduction thermique comprend une couche d'étendue entière déposée au dos du substrat.

7. Composant selon l'une des revendications précédentes, dans lequel la couche déposée en tant que moyen de conduction thermique au dos du substrat se prolonge vers le bas le long d'au moins une surface latérale du substrat jusqu'au support et y est reliée à un puits de chaleur.

8. Composant selon l'une des revendications précédentes, dans lequel les moyens de liaison métalliques sont conçus sous la forme de bossages ou de points de brasage reliant des surfaces de contact sur le substrat à des points de connexion correspondants sur la face supérieure du support.

9. Composant selon l'une des revendications précédentes, dans lequel le moyen de conduction thermique comprend un matériau choisi parmi Al, Ag, Cu, Au, AlN, et SiC.
